Europäisches Patentamt

European Patent Office

Office européen des brevets

(11) Veröffentlichungsnummer: **0 482 400 A1**

# EUROPÄISCHE PATENTANMELDUNG

(21) Anmeldenummer: **91116927.4**

(51) Int. Cl.5: **H03J 1/00**

(22) Anmeldetag: **04.10.91**

(30) Priorität: **26.10.90 DE 4034101**

(43) Veröffentlichungstag der Anmeldung:
**29.04.92 Patentblatt 92/18**

(84) Benannte Vertragsstaaten:
**DE IT SE**

(71) Anmelder: **TELEFUNKEN electronic GmbH**
**Theresienstrasse 2**
**W-7100 Heilbronn(DE)**

(72) Erfinder: **Englmeier, Martin**
**Schubertstrasse 25**
**W-8071 Lenting(DE)**
Erfinder: **Heigl, Franz**
**Frühlingstrasse 12**
**W-8079 Ochsenfeld(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) **Schaltungsanordnung zur Bereichsumschaltung eines Tuners.**

(57) Es wird eine neue Schaltungsanordnung zur Bereichsumschaltung eines Tuners angegeben, wobei für verschiedene Tunertypen deren Bereichsumschaltsignal von einem programmierbaren PLL-Schaltkreis gleichzeitig erzeugt werden. Somit kann für mehrere Tunertypen immer der gleiche PLL-Schaltkreis zur Erzeugung der Bereichsumschaltsignale verwendet werden, wodurch eine kostengünstige Fertigung erzielt wird.

FIG.1

Die Erfindung betrifft eine Schaltungsanordnung mit einem PLL-Schaltkreis zur Bereichsumschaltung eines Tuners gemäß dem Oberbegriff des Patentanspruches 1.

Eine solche Schaltungsanordnung ist aus dem Datenblatt der Firma Philips für den Integrierten Schaltkreis TSA 5510 mit dem Titel "1.3 GHz I²C-BUS Controlled Frequency Synthesizer", Mai, 1989, Seiten 1 - 12, insbesondere Figur 5 auf Seite 10 bekannt. Dieser Schaltkreis TSA 5510 enthält alle Abstimmfunktionen einer Nachlaufsynchronisation (phase-locked loop, PLL) eines Fernsehabstimmsystems. Dieser Schaltkreis kann für alle Typen von Fernsehempfängern verwendet werden. Die Steuerdaten für diesen Schaltkreis werden über den sogenannten I²C-BUS zugeführt, über den acht Ausgänge programmierbar sind. Gemäß der Schaltungsanordnung nach der schon oben erwähnten Figur 5 erzeugt dieser Schaltkreis die Bereichsumschaltsignale für drei Frequenzbänder, die über drei Ausgänge P0, P1 und P2 dem eigentlichen Tuner zugeführt werden. Zur Steuerung des Schaltkreises TSA 5510 ist derselbe über eine I²C-BUS-Leitung mit einem Mikrocontroller verbunden.

Die oben beschriebene Schaltung weist den Nachteil auf, daß für jeden Tunertyp der PLL-Schaltkreis in anderer Weise programmiert werden muß, so daß in einer Fertigung für jeden Tunertyp spezielle Programme für die PLL-Schaltkreise zur Verfügung gestellt werden müssen.

Der Erfindung liegt daher die Aufgabe zugrunde, eine Schaltungsanordnung der eingangs genannten Art zu schaffen, die für verschiedene Tunertypen die Verwendung einer einzigen Software zur Ansteuerung des PLL-Schaltkreises ermöglicht.

Die Lösung dieser Aufgabe ist durch die kennzeichnenden Merkmale des Patentanspruches 1 gegeben.

Das Wesen der Erfindung besteht hiernach darin, für mehrere Tunertypen deren Bereichsumschaltsignal gleichzeitig durch den programmierbaren PLL-Schaltkreis erzeugen zu lassen, und diese spezifischen Bereichsumschaltsignale jeweils auf eine Gruppe von Ausgängen zu führen, so daß jede Gruppe von Ausgängen einem bestimmten Tunertyp zugeordnet ist. Somit ist es möglich, für mehrere verschiedene Tunertypen ein und denselben PLL-Schaltkreis und dieselbe Software zu verwenden, womit in der Tunerfertigung eine Senkung der Herstellungskosten möglich ist. Hierbei sind nur die dem eingesetzten Tunertyp entsprechenden Ausgänge des PLL-Schaltkreises belegt, während die übrigen Ausgänge offen bleiben.

Weitere vorteilhafte Ausgestaltungen der Erfindung sind den Unteransprüchen zu entnehmen.

Im folgenden soll die Erfindung anhand eines Ausführungsbeispieles im Zusammenhang mit den Zeichnungen erläutert werden. Es zeigen:

Figur 1    ein Blockschaltbild einer Ausführungsform der Erfindung,

Figur 2    ein Blockschaltbild zur Erzeugung der Bereichsumschaltsignale für einen Tuner mittels der Schaltungsanordnung nach Figur 1.

In den Figuren sind einander entsprechende Bauelemente bzw. Bauelemente gleicher Funktion mit den gleichen Bezugszeichen versehen.

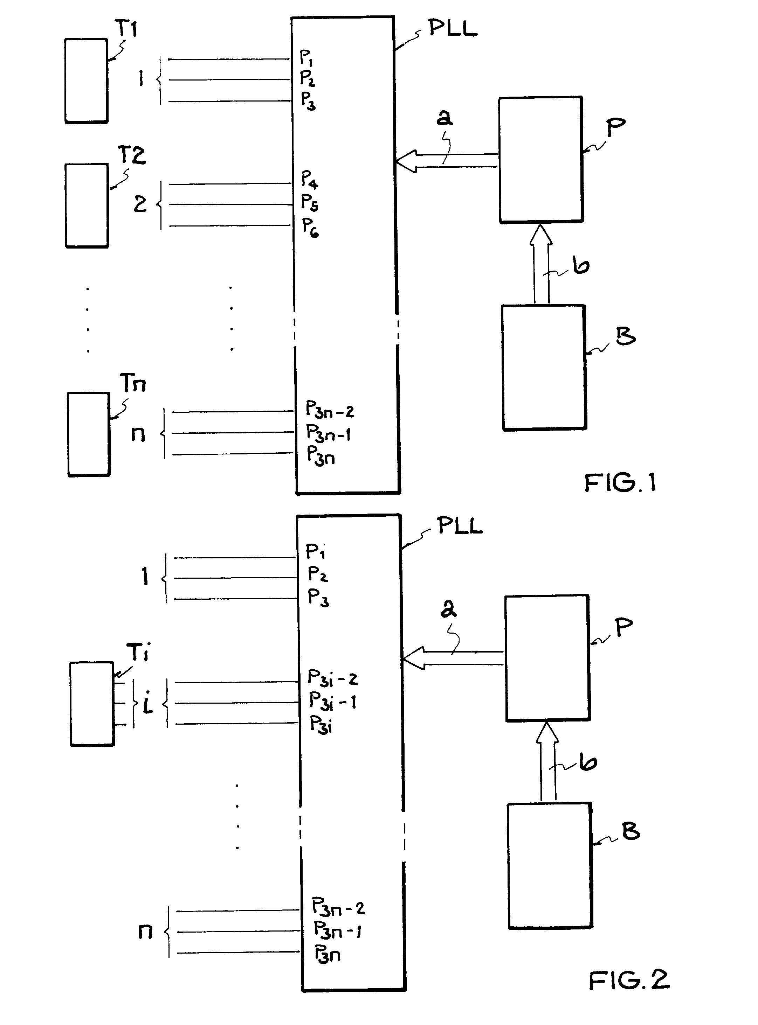

In der Figur 1 sind mit den Bezugszeichen T1, T2 bis Tn Tuner unterschiedlichen Typs bezeichnet. Ein PLL-Schaltkreis PLL wird über eine BUS-Leitung a von einem Mikroprozessor P angesteuert. Eine Bedieneinheit B führt über eine weitere BUS-Leitung b Steuersignale dem Mikroprozessor P zu. Des weiteren weist der PLL-Schaltkreis PLL mehrere Ausgänge P1 bis P(3n) auf, die zu Gruppen von jeweils drei Eingängen zusammengefaßt sind. Eine erste Gruppe 1 besteht aus den Eingängen P1, P2 und P3, eine zweite Gruppe 2 aus den Eingängen P4, P5 und P6 bis zu einer Gruppe n mit den Ausgängen P(3n-2), P(3n-1) und P(3n). An den drei Ausgängen jeder Gruppe werden jeweils Bereichsumschaltsignale für einen bestimmten Tunertyp zur Verfügung gestellt, nämlich für den Frequenzbereich des VHF-Bandes I, für den Frequenzbereich des VHF-Bandes III und für den Frequenzbereich des UHF-Bandes. Der PLL-Schaltkreis PLL wird über den Mikroprozessor P so programmiert, daß er für alle Tunertypen T1 bis Tn gleichzeitig die Bereichsumschaltsignale erzeugt und sie auf die entsprechenden Ausgänge aufschaltet. Durch die Bedieneinheit B kann der Benutzer den gewünschten Empfangsbereich des an die PLL-Schaltung PLL angeschlossen Tuners Ti einstellen.

Eine solche Situation ist in der Figur 2 dargestellt, wonach ein spezieller Tuner Ti mit den Ausgängen P(3i-2), P(3i-1) und P(3i) der Gruppe i verbunden ist. Die anderen Gruppen 1 bis i-1 und i+1 bis n sind nicht belegt. Somit kann in vorteilhafter Weise für n Tunertypen ein und derselbe PLL-Schaltkreis mit einer einzigen Software verwendet werden.

**Patentansprüche**

1. Schaltungsanordnung mit einem PLL-Schaltkreis zur Bereichsumschaltung eines Tuners, wobei der PLL-Schaltkreis mehrere programmierbare Ausgänge aufweist und über eine BUS-Leitung steuerbar ist, dadurch gekennzeichnet, daß der PLL-Schaltkreis (PLL) derart programmiert wird, daß für mehrere verschiedene Tunertypen (T1, ..., Tn) deren Bereichsumschaltsignale gleichzeitig erzeugt werden, daß für jeden Tunertyp (T1, ..., Tn) eine Gruppe von Ausgängen (P1, P2, P3; P4, P5, P6; ...; P(3n-2), P(3n-1), P(3n)) vorgesehen sind, über die dem Tuner die Bereichsumschaltsignale zugeführt werden und daß die für jeden Tuner spezifischen Bereichsumschaltsignale jeweils auf die zugehörige Gruppe von Ausgängen aufgeschaltet werden.

2. Schaltungsanordnung nach Anspruch 1, dadurch gekennzeichnet, daß der PLL-Schaltkreis (PLL) über die BUS-Leitung (a) von einem Mikroprozessor (P) gesteuert wird.

3. Schaltungsanordnung nach Anspruch 2, dadurch gekennzeichnet, daß eine Bedieneinheit (B) vorgesehen ist, die mit dem Mikroprozessor (P) verbunden ist.

4. Schaltungsanordnung nach einem der vorangehenden Ansprüche, dadurch gekennzeichnet, daß jede Gruppe von Ausgängen aus drei Ausgängen besteht.

5. Schaltungsanordnung nach Anspruch 4, dadurch gekennzeichnet, daß ein erster Ausgang für den Frequenzbereich des VHF-Bandes I, ein zweiter Ausgang für den Frequenzbereich des VHF-Bandes II und ein dritter Ausgang für den Frequenzbereich des UHF-Bandes vorgesehen ist.

6. Verwendung der Schaltungsanordnung für jeweils einen Tunertyp nach einem der vorangehenden Ansprüche, wobei die Ausgänge der anderen Gruppen nicht belegt sind.

FIG.1

FIG.2

**Europäisches Patentamt**

**EUROPÄISCHER RECHERCHENBERICHT**

Nummer der Anmeldung

**EP 91 11 6927**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PHILIPS DATA HANDBOOK, I2C-BUS COMPATIBLE ICs. BOOK IC12b 1989. MARCH 1989. PAGES 1279-1288.<br>* das ganze Dokument * *<br>– – – | 1-6 | H 03 J 1/00 |
| A | FUNKSCHAU. Bd. 52, Nr. 4, Februar 1980, MUNCHEN DE Seiten 55 - 58; ING. (GRAD) ANTON KUSSMAUL: 'KOMBINATION VON LOGIK UND NICHTFLUECHTIGEN SPEICHER AUF EINEM CHIP.'<br>* das ganze Dokument * *<br>– – – | 1-6 | |
| A | EP-A-0 336 650   (UNIDEN CORPORATION OF AMERICA)<br>* das ganze Dokument * *<br>– – – – – | 1-6 | |

| RECHERCHIERTE SACHGEBIETE (Int. Cl.5) |
|---|
| H 03 J |

Der vorliegende Recherchenbericht wurde für alle Patentansprüche erstellt

| Recherchenort | Abschlußdatum der Recherche | Prüfer |
|---|---|---|
| Den Haag | 09 Januar 92 | PEETERS M.M.G. |